# EUROPÄISCHE PATENTSCHRIFT

(11) **EP 0 566 606 B1**
(45) Veröffentlichungstag und Bekanntmachung des Hinweises auf die Patenterteilung: **31.05.1995**
(21) Anmeldenummer: 92901885.1
(22) Anmeldetag: 31.12.1991
(51) Int. Cl.: C23C 14/32, H01J 37/305

(54) **VORRICHTUNG UND VERFAHREN ZUR MATERIALVERDAMPFUNG**
DEVICE AND PROCESS FOR THE VAPORISATION OF MATERIAL
PROCEDE ET DISPOSITIF DE VAPORISATION DE MATERIAU

(30) Priorität: 10.01.1991 DE 4100541
(43) Veröffentlichungstag der Anmeldung: 27.10.1993
(73) Patentinhaber: Plasco Dr. Ehrich Plasma-Coating GmbH, 55262 Heidesheim (DE)
(72) Erfinder: EHRICH, Horst, D-4270 Dorsten 11 (DE); HASSE, Brunhilde, D-4300 Essen (DE); HINZ, Hans-Peter, D-4330 Mülheim/Ruhr 11 (DE); MAUSBACH, Michael, D-4600 Dortmund 30 (DE)
(74) Vertreter: Werner, Hans-Karsten, Dr.Dipl.-Chem.
(86) Internationale Anmeldenummer: EP9102525
(87) Internationale Veröffentlichungsnummer: WO9212275

(56) Entgegenhaltungen:
- EP-A- 0 158 972
- US-A- 3 544 763
- JOURNAL OF VACUUM SCIENCE AND TECHNOLOGY A Bd. 6, Nr. 1, 1. Januar 1988,WOODBURY, NY, USA Seiten 134 - 138; H. EHRICH: 'The anodic vacuum arc.I. Basicconstruction and phenomenology'

## Beschreibung

Die Erfindung betrifft eine Vorrichtung zur Materialverdampfung mittels Vakuumlichtbogenentladung in einer Unterdruckkammer mit einer selbstverzehrenden Kathode (2) mit einer kühlbaren Kathodenzuführung (1), auf der die Kathode befestigt ist und einer selbstverzehrenden heißen Anode, wobei an der Anodenbasisplatte (6) über ein Verbindungsstück (7a) ein Tiegel (7) befestigt ist und über der Kathode (2) eine die Kathode abschirmende Blende (13) angeordnet ist, der Tiegel (7) aus einem elektrisch leitfähigen und wärmeleitfähigen Material besteht und das Verbindungsstück (7a) aufgrund seiner Materialeigenschaften oder seiner geometrischen Eigenschaften eine elektrisch leitende und wärmeisolierende Befestigung des Tiegels (7) an der Anodenbasisplatte (6) ermöglicht. Ein weiterer Gegenstand der Erfindung ist ein Verfahren zur Materialverdampfung.

Bei der Erzeugung dünner Überzüge auf Werkstücken durch Aufdampfen von Materialien im Vakuum sind in den letzten Jahren zunehmend die plasma- und ionengestützten Beschichtungsverfahren in den Vordergrund getreten. Dies hat seine Ursache in der besseren Qualität der erzeugten Beschichtungen, die sich insbesondere durch eine bessere Haftung der Schichten und eine kompaktere Schichtstruktur gegenüber den klassischen Verfahren hervorheben.

Zu den bisher industriell eingesetzten bekannten plasmagestützten Beschichtungsverfahren zählen die Kathodenzerstäubung, das Ionenplattieren sowie die Verdampfung durch Lichtbögen. Die Lichtbögen arbeiten sowohl mit Glühkathoden (US-PS 4,197,157) oder Hohlkathoden (US-PS 3,562,141). Beide Kathodenarten benötigen zur Aufrechterhaltung der Bogenentladung ein Prozeßgas.

Eine weitere Gruppe der Lichtbögen sind die sogenannten Vakuumlichtbögen, die ohne Prozeßgas arbeiten. Bei diesen übernimmt verdampftes Elektrodenmaterial die Funktion des Prozeßgases. Der von den sich selbstverzehrenden Elektroden erzeugte Materialdampf dient neben der Aufrechterhaltung der Lichtbogenentladung auch zur Erzeugung von Überzügen auf Werkstücken. So ist aus D.M. Sanders "Review of ion-based coating processes derived from the cathodic arc", J. Vac. Sci.Technol. A7, No. 3, 2339 (1989) ein Vakuumlichtbogen mit selbstverzehrender Kaltkathode bekannt und aus der DE-34 13 891 weiterhin ein Vakuumlichtbogen, bei dem die aus einer selbstverzehrenden Kaltkathode entstehenden Elektronen zur Verdampfung von Material an der Anode verwendet werden.

Dabei ist die als Verdampfungstiegel ausgebildete Anode zu einer kalten Kathode so angeordnet, daß die aus den Kathodenflecken von der Arbeitsfläche der Kaltkathode ausgehenden Plasmaströme die Außenwandung des anodischen Verdampfungstiegels so stark aufheizen, daß das in diesem Verdampfungstiegel befindliche Verdampfungsgut verdampft und der entstehende Materialdampf oberhalb des Tiegels mit den von den Kathodenflecken ausgehenden Plasmaströmen in Wechselwirkung tritt, so daß dieser Materialdampf ionisiert wird.

Ein gemeinsamer Nachteil der erwähnten plasmagestützen Beschichtungsmethoden liegt in den geringen Auftragsraten, die bei industriell einsetzbaren Vorrichtungen unter 1 »m/min liegen. Daraus resultieren bei der Anwendbarkeit plasmagestützter Verfahren im industriellen Maßstab geringe Produktionsgeschwindigkeiten, die mit den klassischen thermischen Aufdampfverfahren, die ohne Überführung des Verdampfungsguts in den Plasmazustand arbeiten, unter Kostengesichtspunkten nicht konkurrieren können.

Das technische Problem der Erfindung besteht darin, eine Vorrichtung und ein Verfahren zur Materialverdampfung bereitzustellen, mit der bzw. dem Auftragsraten von mehr als 1 »m/min erreicht werden, um so eine kostengünstige, qualitativ hochwertige Vakuumbedampfung von Massenartikeln zu ermöglichen.

Das technische Problem wird dadurch gelöst, daß der Tiegel (7) seitlich oberhalb der Arbeitsfläche der Kathode (2a) so nahe an dieser Arbeitsfläche angeordnet ist, daß der Raumwinkel, der von dem vom Anodentiegel (7) abströmenden Metalldampfplasma (9) gebildet wird, gerade nicht durch die Blende (13) so verringert wird, daß eine homogene Bedampfung von Substraten oberhalb des Tiegels (7) nicht mehr möglich ist und die Kathode (2) und die Anode gegenüberliegend angeordnet sind.

Das technische Problem wird weiterhin durch ein Verfahren zur Materialverdampfung mittels Vakuumlichtbogenentladung in einer Unterdruckkammer mit einer selbstverzehrenden Kathode (2) mit einer kühlbaren Kathodenzuführung (1) und einer selbstverzehrenden heißen Anode gelöst, die aus der Anodenbasisplatte (6), einem Verbindungsstück (7a) und dem Tiegel (7) besteht, wobei der Wärmetransport vom Anodentiegel (7) zur Anodenbasisplatte (6) gering gehalten wird, die von den Kathodenflecken ausgehenden Plasmaströme (5a, 5b) auf die Außenwandung des Tiegels (7b) und auf den Materialdampf oberhalb des Tiegels (9) ungehindert einwirken können, so daß ein hoher Verdampfungsgrad erreicht wird und der Tiegel (7) aus einem elektrisch leitfähigen und wärmeleitfähigen Material besteht.

Bei einer besonders bevorzugten Ausführungsform besteht der Tiegel aus Titandiborid, Wolfram oder einer Mischkeramik aus Bornitrid, Titandiborid und Aluminiumnitrid.

Mit dem erfindungsgemäßen Verfahren und der erfindungsgemäßen Vorrichtung werden qualitativ hochwertige Beschichtungen mit Auftragsraten auf Werkstücken von mehr als 1 »m/sec ermöglicht, so daß eine Massenproduktion unter wirtschaftlichen Gesichtspunkten durchführbar wird.

Mit dem erfindungsgemäßen Verfahren konnten in 15 cm Abstand vom Lichtbogen die in Tabelle 1 dargestellten Auftragsraten erreicht werden. Die in den Lichtbogen eingekoppelte Leistung betrug jeweils 3 kW.

**TABELLE 1**

| Verdampfungsmaterial | Tiegelmaterial | Abstand Anode-Kathode | Auftragsrate |
|---|---|---|---|
| Aluminium | TiB₂ | 5 cm | 4,8 »/min |
| Kupfer | W | 5 cm | 6,0 »/min |
| Silber | W | 5 cm | 9,0 »/min |

Die hier aufgeführten Werte für die Auftragsrate lassen sich mit höheren Lichtbogenleistungen steigern.

Die angegebenen Auftragsraten übertreffen bei weitem die mit anderen plasmagestützten bzw. ionengestützten Verfahren erreichbaren Werte. So sind mit der für Beschichtungen am häufigsten angewandten Kathodenzerstäubung selbst bei Anwendung extremer Leistungen von ≦ 50 kW kaum Auftragsraten über 1 »m/min zu erreichen.

Wird die in den Lichtbogen eingebrachte Leistung zugrunde gelegt, so übertreffen die Auftragsraten des erfindungsgemäßen Verfahrens auch bei weitem jene, die mit Lichtbögen mit Glühkathode, Hohlkathode oder selbstverzehrender Kaltkathode ohne Anodenverdampfung erreicht werden.

Das vorliegende erfindungsgemäße Verfahren zeichnet sich somit aus durch eine effektive Ausnutzung der in den Lichtbögen eingebrachten Leistung für den Verdampfungsprozeß. Aufgrund dieser Effektivität lassen sich mit relativ geringen elektrischen Leistungen hohe Verdampfungsraten erreichen.

Weiterhin führt die effektive Ausnutzung der in den Lichtbogen eingebrachten Leistung zu einer geringeren Wärmeproduktion und damit zu einer geringeren Wärmebelastung der zu beschichtenden Werkstücke und einem geringeren Verbrauch an elektrischer Energie und an Kühlwasser.

Aufgrund der schnellen Aufheizung des Verdampfungsguts und der nachfolgend hohen Verdampfungsrate ist das erfindungsgemäße Verfahren auch für eine quasi-kontinuierliche Produktionsweise geeignet, bei der die zu beschichtenden Werkstücke über Schleusen in die Beschichtungskammer hinein- bzw. hinausgelangen und der Bedampfungsprozeß nur während der Verweilzeit des Werkstücks in der Vakuumkammer eingeschaltet wird.

Figur 1 zeigt eine Vorichtung, die zur Durchführung des erfindungsgemäßen Verfahrens geeignet ist.

Figur 2 zeigt die gleiche Vorrichtung, wobei jedoch die Kathode und die Anode in unerwünschter Weise zueinander angeordnet sind.

Figur 3 zeigt eine bevorzugte Anordnung der Vorrichtung nach Figur 1, wobei Anode und Kathode zueinander geneigt angeordnet sind.

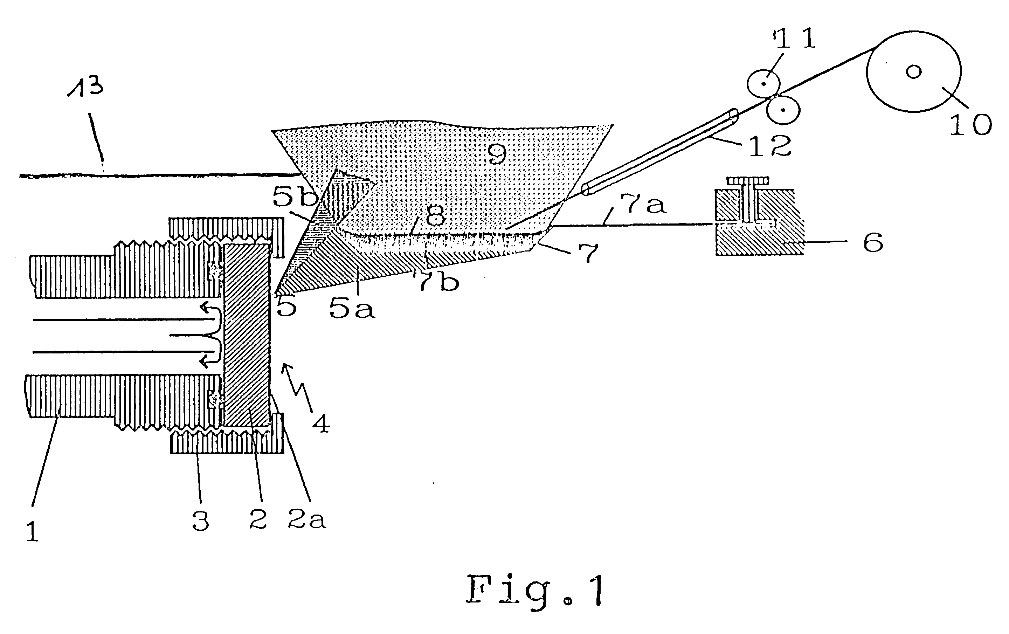

Figur 1 zeigt eine gekühlte Kathodenzuführung (1) mit dem Kathodenmaterial (2) und einer Haltevorrichtung (3) für das Kathodenmaterial (2). Die Vorrichtung (3) dient gleichzeitig zur Fixierung der Kathodenflecke (5) auf der Arbeitsfläche (2a) des Kathodenmaterials (2). Die Lichtbogenentladung wird mittels einer Zündeinrichtung (4), die nur symbolhaft dargestellt ist, nach dem Stand der Technik gezündet.

Die Anode besteht aus einer Anodenhalterung (Anodenbasisplatte) (6), einem Anodentiegel (7) und einer elektrisch leitenden Verbindung (7a) zwischen Halterung (6) und Tiegel (7). Die Verbindung (7a) ermöglicht aufgrund ihrer Material- oder geometrischen Eigenschaften eine elektrisch leitende und wärmeisolierende Befestigung des Tiegels (7) an der Anodenbasisplatte (6). In einer bevorzugten Ausführungsform besitzt das Verbindungsstück (7a) einen so bemessenen elektrischen Widerstand, daß es sich durch den zum Tiegel fließenden Strom aufheizt.

Es ist vorteilhaft, die Verbindung (7a) so auszubilden, daß ein geringer Wärmetransport vom Tiegel (7) zur Halterung (6) stattfindet.

Innerhalb des Anodentiegels (7) ist das Verdampfungsgut (8) angebracht. Verbrauchtes Verdampfungsgut (8) kann durch Material in Drahtform (10) nachgeführt werden. Hierzu ist das nachführbare Material (10) auf einer Drahtrolle gespeichert und wird in der üblichen Art über Antriebsrollen (11) und ein Führungsrohr (12) dem Verdampfungstiegel (7) zugeführt.

Der Anodentiegel (7) ist gegenüber der Arbeitsfläche der Kathode (2a) geometrisch so angeordnet, daß von den Kathodenflecken ausgehende Plasmaströme (5a, 5b) sowohl auf die Außenwandung des Tiegels (7b) als auch auf den Materialdampf (9) oberhalb des Tiegels einwirken. In einer bevorzugten Ausführungsform können die Plasmaströme (5a, 5b) von jeweils getrennten Kathoden ausgehen. Der Plasmastrom (5a), der die Außenwandung (7b) des Tiegels (7) trifft, bewirkt aufgrund der hohen Energien der im Plasmastrom mitgeführten Teilchen (5) eine schnelle und starke Aufheizung des Tiegels und damit auch eine starke Aufheizung des Verdampfungsguts. Es ist daher besonders vorteilhaft, wenn der Tiegel aus einem gut wärmeleitfähigen Material besteht. Diese starke Aufheizung führt zu einer stürmischen Verdampfung des Verdampfungsguts (8). Der Plasmastrom (5b) tritt mit dem Materialdampf (9) oberhalb des Tiegels in Wechselwirkung. Infolge inelastischer Stoßprozesse zwischen den Partikeln des Plasmastroms (5b) und des Materialdampfs führt diese Wechselwirkung zur Ausbildung eines dichten Plasmas oberhalb des Tiegels. Dieses Plasma trifft auf das Verdampfungsgut (8) im Tiegel (7), was zu einer weiteren Energiezufuhr zum Verdampfungsgut und damit Zu einer Steigerung der Verdampfungsgeschwindigkeit führt. Der aus der ionisierten Dampfwolke oberhalb des Tiegels in das umgebende Vakuum abströmende ionisierte Metalldampf kann dann für Beschichtungszwecke genutzt werden.

Für eine qualitativ hochwertige Beschichtung ist es notwendig, die von den Kathodenflecken (5) ausgehenden und im Plasmastrahl (5a, 5b) mitgeführten Metalltröpfchen vom zu beschichtenden Objekt fernzuhalten. Zu diesem Zweck ist die in Figur 1 dargestellte Blende (13) oberhalb der Kathode angebracht, die den kathodischen Plasmastrom (5a, 5b) auf einen Raumbereich außerhalb des zu beschichtenden Objekts begrenzt. Die Blende (13) erfordert einen minimalen Abstand zwischen Arbeitsfläche (2a) der Kathode und Anodentiegel (7), da bei zu geringem Abstand eine unerwünschte räumliche Begrenzung (14) des vom Anodentiegel (7) abströmenden Metalldampfplasmas (9) erfolgt. Der Tiegel (7) ist daher seitlich oberhalb der Arbeitsfläche der Kathode (2) so nahe an dieser Arbeitsfläche angeordnet, daß der Raumwinkel, der von dem vom Anodentiegel (7) abströmenden Metalldampfplasma (9) gebildet wird, gerade nicht durch die Blende (13) verringert wird, so daß noch eine homogene Bedampfung von Substraten oberhalb des Tiegels (7) erfolgt.

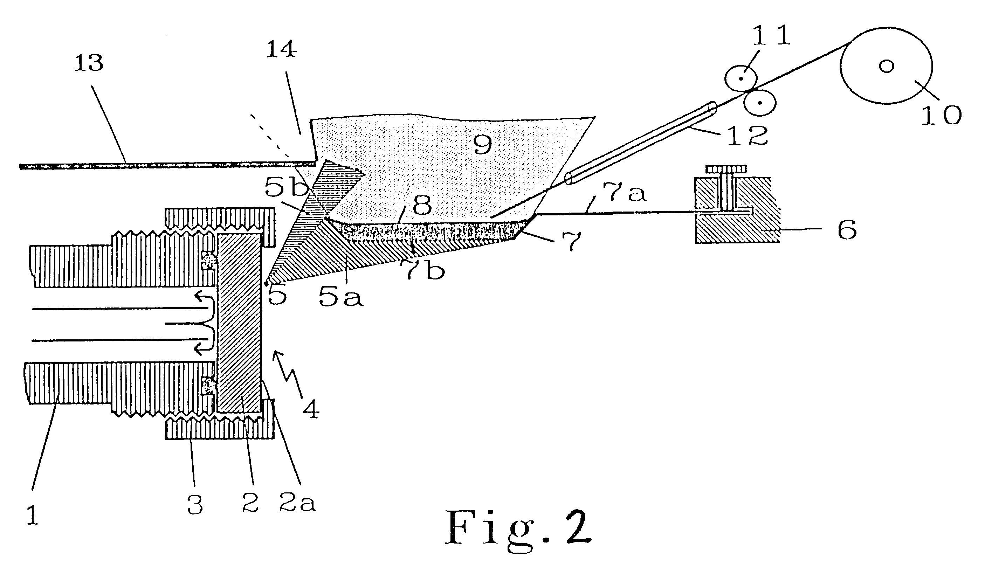

Figur 2 zeigt eine nicht erfindungsgemäße Anordnung von Anode und Kathode, wie sie nicht erwünscht ist. Hier ist der Abstand zwischen der Arbeitsfläche (2a) der Kathode und dem Anodentiegel (7) so gering, daß das abströmende Metalldampfplasma (9) durch die Blende (13) behindert wird. Wenn die Elektroden zu dicht zusammenstehen, wird durch die Abschattung (14) ein Raumwinkel nicht genutzt und in dieser Richtung angeordnete Substrate werden nicht beschichtet.

Zur Erzielung hoher Verdampfungsgeschwindigkeiten ist es vorteilhaft, wenn das Verbindungsstück (7a) zur elektrischen Kontaktierung des Verdampfungsguts (8) und/ oder des Tiegels (7) den Wärmetransport zwischen Tiegel (7) und Halterung (6) behindert. Eine Behinderung des Wärmetransportes kann in einer bevorzugten Ausführungsform dadurch erreicht werden, daß das Verbindungsstück (7a) relativ lang (ca. 5 cm) ist und mit geringem Querschnitt ausgebildet ist. Diese geometrisch verursachte Verringerung des Wärmetransports wird jedoch begrenzt durch die erforderliche mechanische Stabilität des Verbindungsstücks (7a). Weiterhin kann es in einer besonders bevorzugten Ausführungsform vorteilhaft sein, wenn das Verbindungsstück (7a) einen so bemessenen elektrischen Widerstand besitzt, daß infolge des Stromflusses im Lichtbogen das Verbindungsstück (7a) durch diesen Stromfluß aufgeheizt wird und hierdurch eine Wärmeabfuhr vom Tiegel (7) zur Halterung (6) verhindert wird oder die elektrische Aufheizung des Verbindungsstücks (7a) durch den Stromfluß sogar eine zusätzliche Energiezufuhr zum Tiegel (7) bewirkt. Weiterhin ist es vorteilhaft, wenn ein möglichst großer Teil der Außenwandung (7b) des Tiegels vom Plasmastrom (5a) beaufschlagt wird. Dies wird besonders günstig dadurch erreicht, daß die Anode der Kathode gegenüberliegend angeordnet ist und der Tiegel (7) seitlich oberhalb der Arbeitsfläche der Kathode (2a) angebracht ist. Der Tiegel (7) soll weiterhin aus einem gut wärmeleitfähigem Material bestehen, damit die Wärme von der Tiegelaußenwandung (7b) effektiv zum Verdampfungsgut geleitet wird.

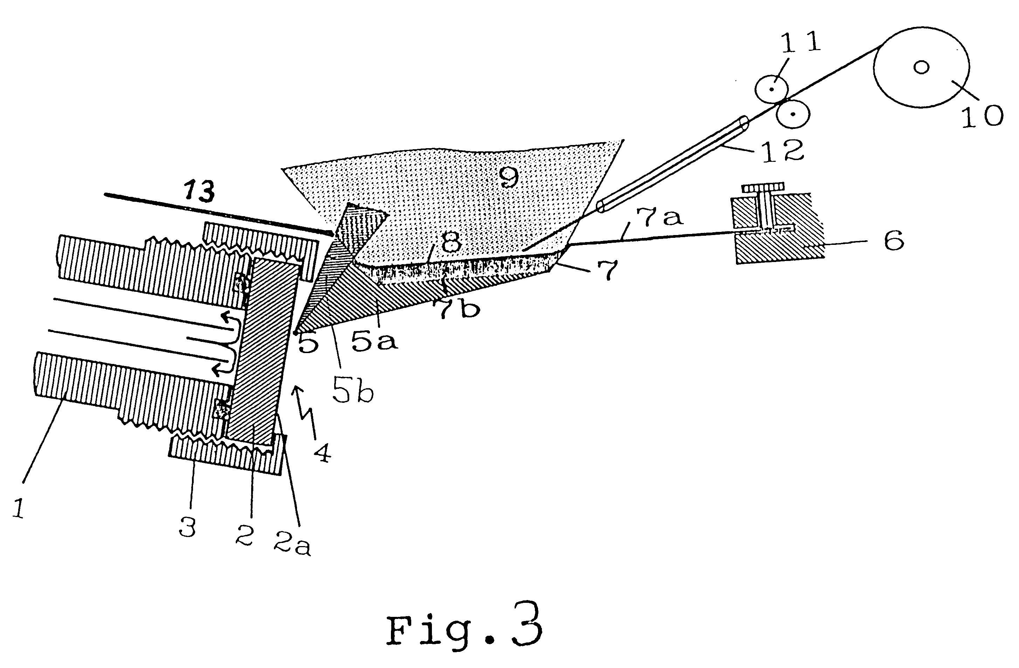

Figur 3 zeigt eine Anordnung, in der eine Kathode und eine Anode etwas geneigt zueinander angeordnet sind. Diese Anordnung bietet den Vorteil, daß einmal das schmelzflüssige Verdampfungsgut (8) infolge der Schwerkraft zur Anodenspitze (zur Kathode weisendes Ende des Verdampfungstiegels (7)) fließt. Die Anodenspitze wird aufgrund der Nähe zur Kathode besonders stark durch den Plasmastrom (5a) aufgeheizt. Die Schrägstellung des Tiegels (7) bewirkt eine stetige Benetzung der Anodenspitze mit schmelzflüssigem Verdampfungsgut und damit eine effektive Verdampfung.

Zum anderen bewirkt die Schrägstellung eine weitere Einengung des vom Plasmastrom (5a, 5b) durchsetzten Raumbereiches oberhalb des Tiegels (7), so daß ein größerer Raumbereich für Beschichtungszwecke zur Verfügung steht.

## Patentansprüche

1. Vorrichtung zur Materialverdampfung mittels Vakuumlichtbogenentladung in einer Unterdruckkammer mit einer selbstverzehrenden Kathode (2) mit einer kühlbaren Kathodenzuführung (1), auf der die Kathode befestigt ist und einer selbstverzehrenden heißen Anode, wobei an der Anodenbasisplatte (6) über ein Verbindungsstück (7a) ein Tiegel (7) befestigt ist und über der Kathode (2) eine die Kathode abschirmende Blende (13) angeordnet ist, der Tiegel (7) aus einem elektrisch leitfähigen und wärmeleitfähigen Material besteht und das Verbindungsstück (7a) aufgrund seiner Materialeigenschaften oder seiner geometrischen Eigenschaften eine elektrisch leitende und Wärmeisolierende Befestigung des Tiegels (7) an der Anodenbasisplatte (6) ermöglicht, dadurch gekennzeichnet, daß der Tiegel (7) seitlich oberhalb der Arbeitsfläche der Kathode (2a) so nahe an dieser Arbeitsfläche angeordnet ist, daß der Raumwinkel, der von dem vom Anodentiegel (7) abströmenden Metalldampfplasma (9) gebildet wird, gerade nicht durch die Blende (13) so verringert wird, daß eine homogene Bedampfung von Substraten oberhalb des Tiegels (7) nicht mehr möglich ist und die Kathode (2) und die Anode gegenüberliegend angeordnet sind.

2. Vorrichtung nach Anspruch 1, dadurch gekennzeichnet, daß der Tiegel (7) aus Titandiborid, Wolfram oder einer Mischkeramik aus Bornitrid, Titandiborid und Aluminiumnitrid besteht.

3. Vorrichtung nach den Ansprüchen 1 oder 2, dadurch gekennzeichnet, daß das Verbindungsstück (7a) zur Aufheizung durch den zum Tiegel fließenden Strom einen geeignet bemessenen elektrischen Widerstand besitzt.

4. Verfahren zur Materialverdampfung mittels Vakuumlichtbogenentladung unter Verwendung einer Vorrichtung nach den Ansprüchen 1 bis 3, bei dem der Wärmetransport vom Anodentiegel (7) zur Anodenbasisplatte (6) gering gehalten wird und die von den Kathodenflecken ausgehenden Plasmaströme (5a, 5b) auf die Außenwandung des Tiegels (7b) und auf den Materialdampf oberhalb des Tiegels (9) ungehindert einwirken, so daß ein hoher Verdampfungsgrad erreicht wird.

5. Verfahren nach Anspruch 4, dadurch gekennzeichnet, daß für die Plasmaströme (5a, 5b) jeweils getrennte Kathoden eingesetzt werden.

## Claims

1. A device for vaporizing material using a vacuum arc discharge in a vacuum chamber with a self-consuming cathode (2) having a cathode supply (1) that can be cooled and to which the cathode is attached, and a self-consuming hot anode, wherein, via connecting member (7a), a crucible (7) is attached to the anode base plate (6), and a diaphragm (13) shielding the cathode (2) is arranged above same, the crucible (7) consists of an electrically conductive and heat-conductive material, and the connecting member (7a), due to its material properties or geometrical properties, permits electrically conductive and heat-insulating attachment of crucible (7) to the anode base plate (6), characterized in that the crucible (7) is arranged laterally above the working surface of the cathode (2a) that close to said working surface that the solid angle formed by the metal vapor plasma (9) flowing off from the anode crucible (7) is just not decreased by the diaphragm (13) in such fashion that homogenous vapor coating of substrates above the crucible (7) is no longer possible, and the cathode (2) and the anode are arranged opposite to each other.

2. The device of claim 1, characterized in that the crucible (7) consists of titanium diboride, tungsten or a mixed ceramic of boron nitride, titanium diboride and aluminum nitride.

3. The device of claims 1 or 2, characterized in that the connecting member (7a) has an electrical resistance dimensioned such that it is heated up by the current flowing to the crucible.

4. A process for vaporizing material by means of a vacuum arc discharge using a device according to claims 1 to 3, in which process heat transfer from anode crucible (7) to anode base plate (6) is kept low and the plasma jets (5a, 5b) emerging from the cathode spots are unimpeded in their action on the outer wall (7b) of the crucible and on the material vapor (9) above the crucible so that a high degree of vaporization is obtained.

5. The process according to claim 4, characterized in that separated cathodes are used for each plasma jet (5a,5b).

## Revendications

1. Dispositif de vaporisation de matériaux au moyen d'une décharge d'arc sous vide dans une chambre de dépression comportant une cathode (2) autoconsommable pourvue d'un moyen d'avance de cathode (1) qui peut être refroidi, sur lequel est fixée la cathode, et une anode autoconsommable chaude, un creuset (7) étant fixé à la plaque de base anodique (6) grâce à un élément de liaison (7a), et un écran (13) protégeant la cathode étant disposé au-dessus de la cathode (2), le creuset (7) étant constitué d'un matériau conducteur de l'électricité et de la chaleur, et l'élément de liaison (7a) permettant de fixer le creuset (7) à la plaque de base anodique (6) d'une manière conduisant l'électricité et isolant de la chaleur en raison des propriétés de son matériau ou de ses caractéristiques géométriques,
caractérisé en ce que le creuset (7), est monté, latéralement en hauteur par rapport à la surface de travail (2a) de la cathode, à une proximité telle de ladite surface de travail que l'angle solide qui est formé par le plasma du métal vaporisé s'écoulant du creuset anodique (7), n'est justement pas réduit par l'écran (13), d'une manière telle qu'une vaporisation homogène de substrats situés au-dessus du creuset (7) ne soit plus possible, et que la cathode (2) et l'anode sont disposées l'une en face de l'autre.

2. Dispositif selon la revendication 1, caractérisé en ce que le creuset (7) est constitué de diborure de titane, de tungstène ou d'une céramique mixte constituée de nitrure de bore, de diborure de titane et de nitrure d'aluminium.

3. Dispositif selon l'une quelconque des revendications 1 ou 2, caractérisé en ce que l'élément de liaison (7a), destiné à chauffer par l'intermédiaire du courant circulant en direction du creuset, présente une résistance électrique d'une valeur appropriée.

4. Procédé de vaporisation de matériau au moyen d'une décharge d'arc sous vide en utilisant un dispositif selon les revendications 1 à 3, dans lequel le transport de chaleur du creuset anodique (7) à la plaque de base anodique (6) est maintenu à un faible niveau et dans lequel les flux de plasma (5a, 5b) provenant des taches cathodiques agissent librement sur la paroi extérieure (7b) du creuset et sur la vapeur de matériau (9) au-dessus (ou dans la partie haute) du creuset, de sorte que l'on obtient un degré de vaporisation élevé.

5. Procéde selon la revendication 4, caractérisé en ce qu'on utilise des cathodes distinctes pour chacun des flux de plasma (5a, 5b).
